# EUROPEAN PATENT APPLICATION

(11) **EP 2 426 724 A1**
(43) Date of publication of application: **07.03.2012**
(21) Application number: 10175311.9
(22) Date of filing: 03.09.2010
(51) Int. Cl.: H01L 31/0384, H01L 31/0352, H01L 31/18, B82Y 20/00, H01L 31/068, H01L 21/265, H01L 31/0224

(54) **Process for the production of photovoltaic cells**

(71) Applicant: Facultés Universitaires Notre-Dame de la Paix, 5000 Namur (BE)
(72) Inventor: Yedji, Mourad, B-5000, NAMUR (BE); Terwagne, Guy, B-5340, GESVES (BE)
(74) Representative: pronovem

(57) **Abstract**

The present invention is related to a process for the manufacturing of a photovoltaic cell comprising the steps of:
- providing a semiconductor substrate said semiconductor substrate comprising an insulating layer on its top surface;
- implanting semiconductor ions selected from the group consisting of silicon, germanium and their mixture by ionic implantation in the insulating layer for obtaining an implanted insulating layer, the ionic implantation fluence being higher than 1.10¹⁷at./cm², the maximum semiconductor concentration in the insulating layer after implantation being higher than the solubility of the semiconductor in the insulating layer;
- thermally treating the implanted insulating layer for inducing the precipitation of the semiconductor into quantum dots;
- depositing at least two conducting contacts for collecting, in use, the generated current.

## Description

### Field of the Invention

The present invention is related to a process for producing photovoltaic cells.

### State of the Art

In the 1970's silicon materials were investigated for so called conventional photovoltaic applications commonly known by the term first generation photovoltaic cells where the modules were based on crystalline silicon including the mono- and the polycrystalline silicon.

Recently, owing to the need for energy without carbon dioxide emissions, silicon has made a comeback, playing a crucial role in modern photovoltaic applications which exploit the advantageous quantum confinement effect in silicon quantum dots (Si-QDs). When a single incoming high energy photon interacts with the photovoltaic cell surface an electron-hole pair is generated and the rest of the energy is lost as heat. The current idea is to harness this energy (lost through thermal effects) to create a second or more electron emission.

This technology based on multiple exciton generation (MEG) is known as one of the third generation photovoltaic cells. Amidst the latest developments in Si-QDs synthesis for photovoltaic applications, we distinguish the elaboration of quantum dots (QDs) by means of magnetron plasma deposition. Other analogical works have been performed by Nozick et al. especially using PbS, PbSe, PbTe, CdS, CdSe, and InAs materials.

Other researchers have chosen to investigate photovoltaic cells with silicon nano-wires either by a vapor-liquid-solid process (VLS) or by hot-wire chemical vapor deposition (HWCVD). Sometimes nanowires are used as efficient charge transport channels between the QDs to make easy carrier transport and collection.

Silicon nanocrystals in the form of a powder were developed and incorporated in liquid silica by chemical way and subsequently used in photovoltaic cells as described in "Silicon nanocrystals as light converter for solar cells", Thin Solid Films, 451-452 (2004) 384 by V. Svrcek et Al.

Ion implantation is a known process for doping surface layers of semiconductors to produce p-n junction. In that case, the fluence, the implantation energy and the subsequent thermal treatment are adjusted to obtain very small doping concentration. The fluence is then typically less than 10¹⁶at./cm² to avoid precipitation of the dopant and maintain acceptable carrier mobility and lifetime.

### Aims of the Invention

The present invention aims to provide a process for the production of photovoltaic cells that does not present the drawbacks of prior art.

The present invention also aims to provide photovoltaic cells produced by the process.

Advantages of the invention will be apparent from the following description.

### Summary of the Invention

The present invention is related to a process for the manufacturing of process for the manufacturing of a photovoltaic cell comprising the steps of:
- providing a semiconductor substrate said semiconductor substrate comprising an insulating layer on its top surface;
- implanting semiconductor ions selected from the group consisting of silicon, germanium and their mixture by ionic implantation in the insulating layer for obtaining an implanted insulating layer, the ionic implantation fluence being higher than 1.10¹⁷at./cm², the maximum semiconductor concentration in the insulating layer after implantation being higher than the solubility of the semiconductor in the insulating layer;
- thermally treating the implanted insulating layer for inducing the precipitation of the semiconductor into quantum dots;
- depositing at least two conducting contacts for collecting, in use, the generated current.

According to particular preferred embodiments, the process of the invention comprises one or a suitable combination of the following features:
- the at least two conducting contacts consist of a front and a back contact;
- the at least two conducting contacts are located on the back side of the photovoltaic cell;
- the thermal treatment is performed at a temperature above 900°C;
- the implantation is performed with ions having an average energy between 15 and 100 keV, preferably between 20 and 80 keV;
- the semiconductor ions energy distribution is a single energy distribution(Gaussian profile);
- the semiconductor ion fluence of the ionic implantation is higher than 1,4x10¹⁷at./cm², preferably about 2x10¹⁷at./cm²;
- the semiconductor ions energy distribution is a multiple energy distribution(plateau profile);
- the semiconductor ion fluence of the ionic implantation is comprised between 2.1x10¹⁶ and 1.4x10¹⁷ at./cm²;
- the maximum excess concentration of the implanted ions in the insulating layer is comprised between 20 and 36 atomic percent, preferably about 28 atomic percent;
- the process further comprises the step of implanting dopant, preferably boron or phosphorous, said step being performed after the thermal treatment;
- the fluence of said dopant is comprised between 7.5x10¹⁴ and 1.5x10¹⁵ at./cm²;
- the dopant concentration after implantation is comprised between 0,1 and 0,2 at.%;
- the insulating layer thickness is comprised between 100 and 300 nm;
- the insulating layer is an oxide of the substrate semiconductor;
- the insulating layer is selected from the group consisting of nitride or carbide of the semiconductor substrate;
- the semiconductor substrate is selected from the group consisting of silicon and germanium.

### Brief Description of the Drawings

Fig. 1. Represents schematically of an example of process according to the invention with front and back conducting contacts.

Fig. 2. represents Backscattering spectra using 2 MeV α particles recorded from the SiO₂/Si sample implanted with 70 keV Si ions at a fluence D = 2x10¹⁷ Si/cm² (a), effect of the annealing time on Si depth profiles extracted from RBS measurements (b).

Fig. 3. Represents the effect of the annealing time on Si depth profiles extracted from RBS measurements of sample implanted with a Si multiple energy implantations of 20, 35, 80 keV to fluences of 2.1 x 10¹⁶, 4.2 x 10¹⁶ and 1.4 x 10¹⁷ Si⁺/cm². Si depth profile becomes more uniform after 1 hour annealing time.

Fig. 4. illustrates the effect of the annealing time at 1100 °C on the PL-spectra for different implanted fluences: (a) 6 x 10¹⁶ Si/cm², (b) 1 x 10¹⁷ Si/cm², (c) 1.4 x 10¹⁷ Si/cm², (d) 2 x 10¹⁷ Si/cm². All samples were passivated.

Fig. 5. illustrates the effect of implanted fluence on the PL-spectra recorded in unpassivated samples for a fixed annealing time at 60 min.

Fig. 6. represents TEM images of Si QDs in 240 nm SiO₂.

Fig. 7 represents an example of a photovoltaic cell produced according to the invention, having a continuous layer transparent front contact (TCO: transparent conducting oxide, such as Indium Tin Oxide or the like).

Fig. 8 represents an example of a photovoltaic cell produced according to the method of the invention, having both conducting contacts located on the rear side, with vias.

Fig. 9 represents a cross section of an example of a photovoltaic cell produced according to the invention with back contacts only and without vias.

Fig. 10 represents a 3D view of a photovoltaic cell according to the invention showing interdigitated back contacts.

### Detailed Description of the Invention

The present invention is related to a process for producing photovoltaic cells using quantum dots in their active areas. Such kind of QDs permits to improve the average efficiency of photovoltaic devices. More particularly, the present invention aims to provide a simplified process for producing photovoltaic cells oxide layers containing semiconductors QDs while maintaining a good control of QDs size, distribution and density.

The present invention also provides QDs production without contaminating the substrate with potential impurities and thus reduces oxide layer contamination.

In particular embodiments of the present invention, the diffusion of the doping agent toward the substrate is also avoided.

The first step of the process of the invention is to provide a semiconductor substrate comprising an insulating layer on its top surface.

The semiconductor is preferably selected from the group consisting of silicon and germanium.

Preferably, the insulating layer is obtained by chemically treating the surface of the semiconductor with oxidizing, carburizing or nitridizing species. In case of a silicon substrate, this produces silicon dioxide, silicon carbide or silicon nitride insulating layer.

Alternatively, said insulating layer can be obtained by chemical vapour deposition, or any alternative deposition method known in the art.

In the next step, semiconductor ions are implanted in the insulating layer, resulting in an excess of the atomic concentration of the semiconductor in comparison with the stoechiometric composition of the insulating layer. Preferably, the maximum excess concentration of said semiconductor is comprised between 20 and 36%, preferably about 28%.

The implanted semiconductor ion is preferably selected from the group consisting of silicon and germanium.

Contrary to usual implantation fluence, it has been found that best results were obtained with very high ion fluence, above 1x10¹⁷at./cm². Best results were obtained with fluence of 2x10¹⁷ at. /cm². For higher fluence, the QDs density becomes too high, and the control of coalescence of the QDs becomes difficult, rendering the control of QDs sizes complicated.

Preferably, the energy profile of the ions during the implantation comprises several energies, leading to a rectangular implantation profile (plateau profile). This is usually obtained by using several quasi monoenergetic ion beams (Gaussian profile). For that reason such kind of plateau profile are usually called "multiple implantations". The main advantage of such multiple implantations is to obtain Si-QDS distributed from the extreme surface of the insulating layer to the insulating layer/semiconductor interface thereby improving cells efficiency. Plateau energy profile can be obtained by any other method known in the art.

The obtained implanted insulator is then thermally treated at a sufficient temperature sufficient to induce nucleation and growth of the semiconductor atoms in excess to stoechiometric composition, thereby producing QDs.

The thermal treatment temperature is selected in order to control QDs density (number of nucleus) and size: larger temperature induces lower number of nucleus and increases growth of the nucleus, giving rise to lower number of larger QDs.

Larger treatment time induces growth of the QDs until equilibrium is reached (no more semiconductor in excess to stoechimetry in the insulating phase). At that time, only coalescence can still occur, which is detrimental to the QDs distribution and density.

Preferably, the thermal treatment is performed at a temperature above 1000°C, more preferably about 1100°C.

In order to avoid oxide growth during the thermal treatment, and consumption of the excess semiconductor by oxidation, the thermal treatment is preferably performed in an inert atmosphere such as nitrogen.

Thermal treatment times of 15 min, 30 min, 45 min and 60 min have been used, 60 min showing the best results.

The QDs can then be doped by any suitable dopant by an additional implantation step. The dopant can be either of p-type in case of n-type substrate or n-type in case of p-type substrate, generating a p-n or n-p junction for collecting the charge carrier generated by incoming light. Preferably, p-type dopant is boron. Advantageously, n-type dopant is Phosphorous.

It is an advantage of the present invention that the implantation of dopant is performed after the thermal treatment inducing the generation of the QDs, avoiding the diffusion of said dopant toward the substrate.

A second thermal treatment can advantageously be performed after implantation of the dopant to obtain the final junction structure, with dopant at substitution sites, and relaxing defects induced by the implantation process.

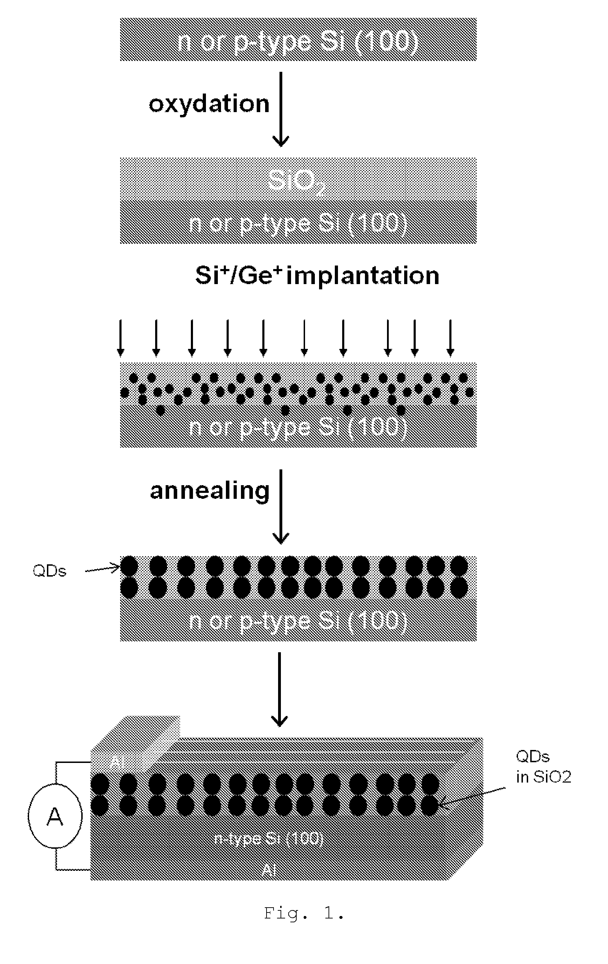

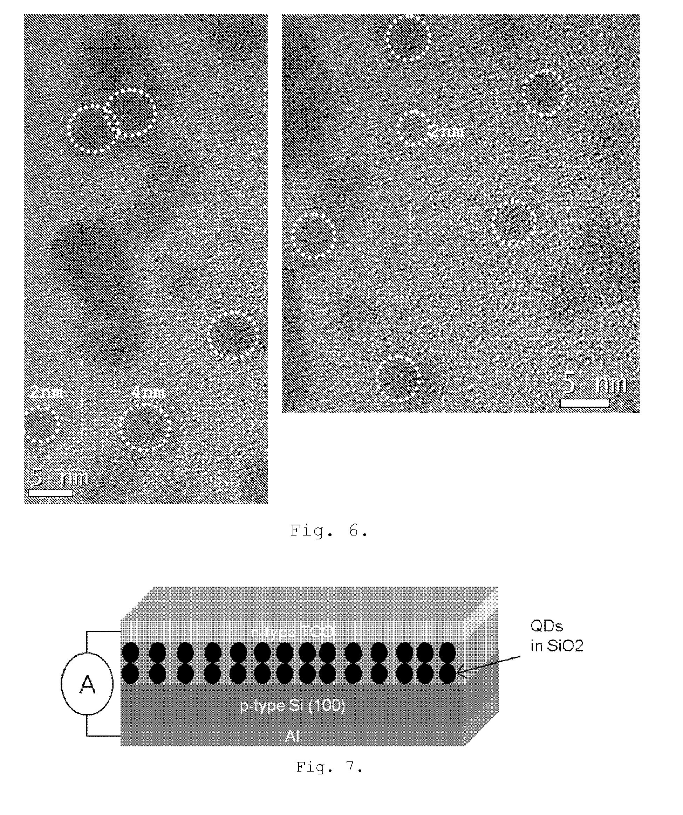

Front and back contacts may then be deposited on front and back surface of the substrate. Front contact can be either opaque electrode covering partially the produced photovoltaic cell as represented in Fig. 1, or transparent conducting electrodes, such as those produced by ITO material as represented in Fig. 7. Back contact can be opaque electrode, preferably aluminium.

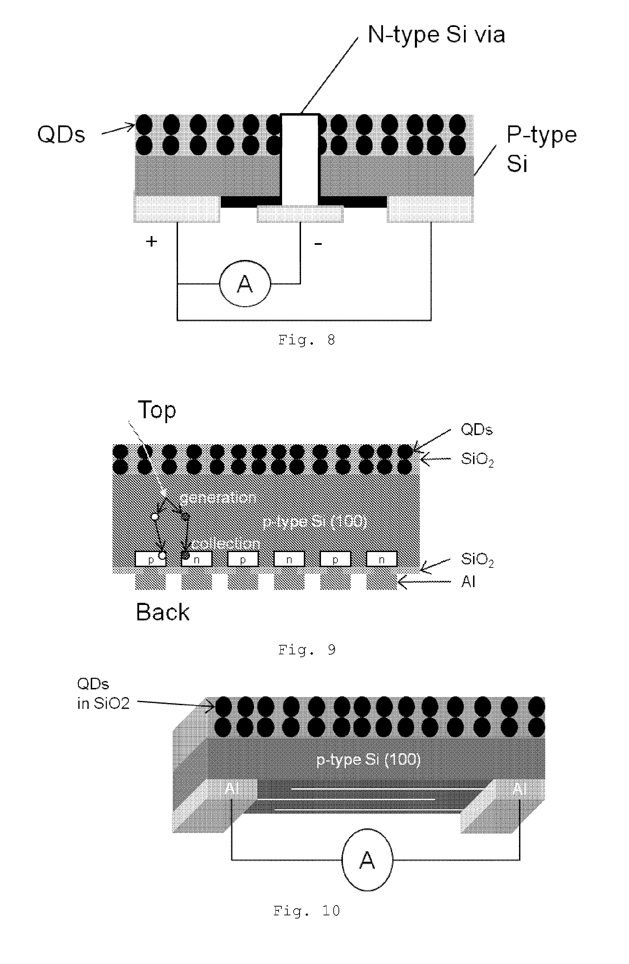

Alternatively, all contacts may be located on the back side of the cell as represented in Fig. 8. This kind of design advantageously reduces the shadowing of the cell by the contacts, thereby improving the conversion efficiency of the photovoltaic cell. The current arising from the front layer may be collected in this case by any known methods, for example through vias, such as described in patent application US 2004/261839 or according to the so called emitter wrap-through technology, such as described in in document WO 2009/077103.

Even more advantageously, back conducting contacts are deposited on alternating P+ doped area and N+ doped area, without vias, as represented in Fig. 9. As shown in this figure, excitons produced in the QD's diffuses through the substrate and the charge carriers are then separated and collected by the electrical fields induced by the PN junctions on the back side. Said conducting contacts on the rear side may advantageously form at least two interdigitated grid electrodes as represented in fig. 10.

Alternatively, the photovoltaic cell of the present invention can be included in a larger stack of cells, the back contact of the photovoltaic cell of the invention being the top electrode of the subsequent cell in the stack.

### Example

All SiO₂/Si samples were produced by thermal oxidation, at high temperature (∼ 1100°C under oxygen flow), of a Si (100) wafer. The gas flow was about ∼ 1 L/min.

The thickness and stoichiometry of all oxides were determined by both (RBS) and ellipsometry techniques. Both techniques prove the high quality of the oxide in terms of stoichiometry and purity. The results obtained by ellipsometry show that the variation of refractive index of the oxide layers is very close to the theoritical SiO₂ curves. From this it can be concluded that these layers are perfectly stoichiometric. A series of thin oxide layers were thermally synthesised and characterized with the above conditions and their thickness were between 100 and 300 nm.

One of the main problems was that during the oxidation, the oxide was grown onto both top and bottom surfaces of the wafer. To solve this problem, development process was used, namely, coating surface A (top) with a photoresist, then submerging the sample in a HF (5%) bath to remove the oxide from the back surface and finally the use of an organic solvent to remove the polymer from the surface A.

These samples were implanted with Si⁺ ions, at 70 keV with different doses of 6 x 10¹⁶, 1 x 10¹⁷, 1.4 x 10¹⁷ and 2 x 10¹⁷ Si⁺ /cm². Additionally multiple energies implantations were performed with energies of 20, 35, 80 keV to fluences of 2.1 x 10¹⁶, 4.2 x 10¹⁶ and 1.4 x 10¹⁷ Si⁺ /cm².

The wafers were then annealed at 1100°C under nitrogen flow for 15, 30, and 60 min. Special care was taken to avoid oxidation of the samples inside the furnace.

SiO₂ implanted coupons of 1 x 1 cm² were specially cut for cell fabrication, they were doped by 26 keV B⁺ ions with a fluence of 1.5 x 10¹⁵ B⁺/cm² and heated at 800°C.

A comb electrode on top side was deposited by evaporation through a mask whereas back contact was achieved by the deposition of an Al layer. The thickness of the Al contacts was 800 nm. One of the advantages of ion implantation is that Boron implantation (for doping) is performed after annealing (QD's precipitation annealing), thus ensuring that there is no diffusion of the doping element into the interface.

Rutherford Backscattering Analysis (RBS) was performed with 2 MeV α particles, at a detection angle of 165°, using a 2 MV Tandetron accelerator. During the RBS analysis, a spot of luminescence which has the same dimension of the ion beam was observed only in the annealed samples when they were struck by the incoming ion beam, this is due to Si-nc luminescence.

Channelling behaviour was observed for the annealed samples, which became accentuated with increasing annealing time.

This was not the case for un-annealed implanted samples. This observation shows that annealing can re-crystallise and recombine defects created by ion implantation. It can be noticed that this behaviour can also be a result of subtract channelling. To prevent this channelling, the incident angle was set at 7°.

Transmission electron microscopy images were performed using a 200 KV FEG (Field Emission Gun).
The photoluminescence (PL) measurements were carried out using a USB2000 Ocean Optics spectrograph and a 1 mW nm laser diode.

In the passivation case, the samples were passivated in hydrogen by annealing at 500 °C for 60 min in an atmosphere of 5% H₂ + 95% N₂. Measurements of the PL were taken at room temperature using an argon laser (Ar⁺) at 405 nm, with a nominal power of 15mW. The range of detection of the spectrograph covers wavelengths from 530 to 1100 nm.

Finally, the electrical properties of photovoltaic devices were characterized in the dark at ambient temperature by an Agilent B1500 with a 4 solar measurement units (SMUs) and a 2 SMUs which have resolutions of 10 fA and 0.1 fA respectively. It has a very stable measurement circuit with a resolution of 0.1fA on the most sensitive range and can measure up to 100 mA.

I-V characteristics for illuminated cells were measured by an AM1.5G terrestrial photovoltaic lamp. The spectrum of AM1.5G photovoltaic simulator lamp is considered to be similar to the Belgian sunlight.

I-V measurements under illumination were performed with a Keithley 2400 source-meter which allows sourcing and measuring voltage from ± 5µV (sourcing) and ± 1µV (measuring) to ± 200V DC and current from ± 10pA to ± 1A. The measurements were performed in a dark room which was shielded from most of external electromagnetic waves.

### Results and discussion

### Depth profiles

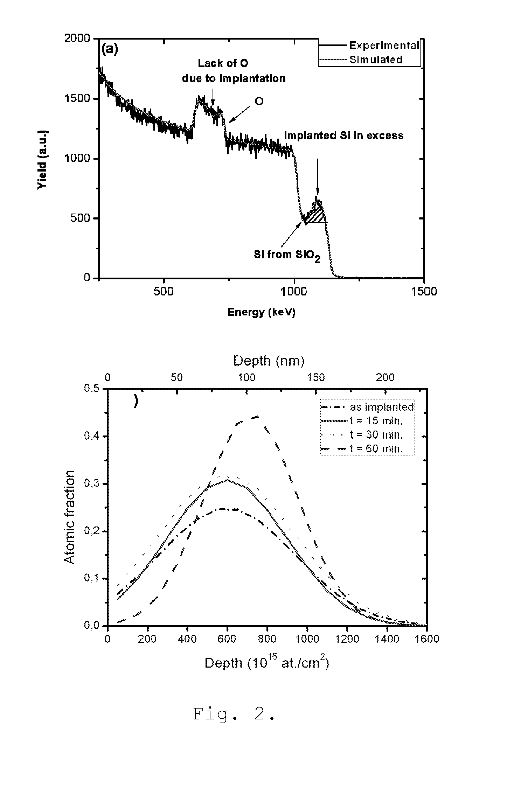

Figure 2 (a) shows RBS spectra recorded on the 240 nm SiO₂/Si sample implanted with 70 keV Si ions with fluence of 2 ×10¹⁷ Si/cm⁻². A Gaussian-shape peak arises from ions backscattered from surface of the SiO₂ and the falls in the SiO₂/Si interface reveals exactly the Gaussian distribution of the 70 keV Si ions into the 240 nm silicon oxide layer.

The range of the implanted ions is about 100 nm with typically FWHM of 100 nm. Theoretical calculations have expected a sputtering of about 40 nm, resulting in the oxide layer being completely covered by the implanted ions.

Figure 2 (b) shows depth profiles extracted from the RBS spectra. The depth profile of the implanted sample (as-implanted) shows a maximal excess concentration of 28 at.%. A comparison of results obtained from annealed samples reveals that the Si depth distribution is not significantly modified for annealing times less than 30 minutes, but the contribution from the matrix is increased (12 to 28 %). This indicates that small Si-nc are progressively formed. There is evidence in Fig. 2 (b) that for 60 minutes annealing, the depth distribution narrows, whilst the maximum concentration increases as the Si ions diffuse to the interface.

### Photoluminescence measurements (PL)

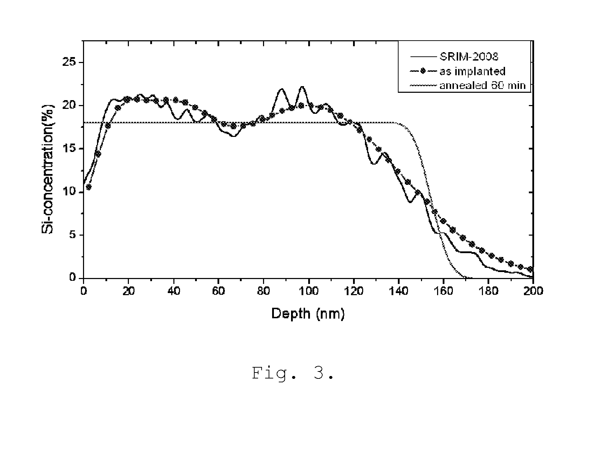

All implanted, heated and passivated samples exhibit photoluminescence emission with PL peaks at ∼ 800 nm and 890 nm. The 800 nm peak is observed for samples implanted with fluences of 6 x 10¹⁶ Si/cm² and 1 x 10¹⁷ Si/cm² (Fig. 3 (a) and (b)).

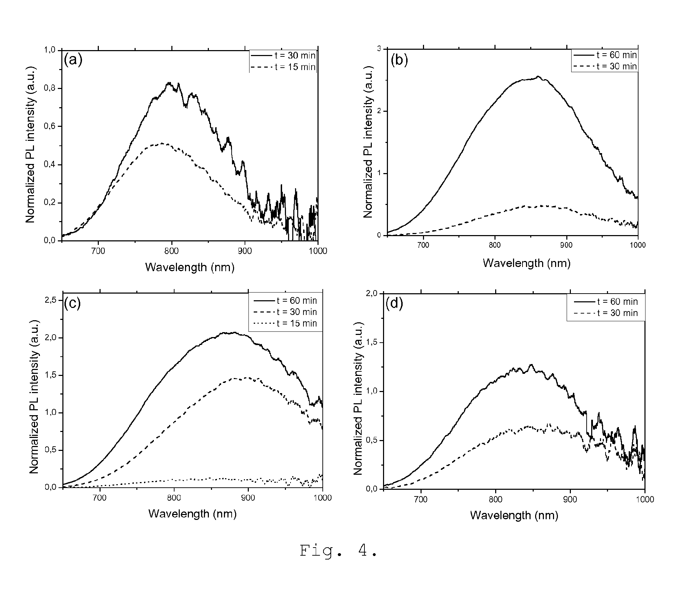

There is evidence that this peak is redshifted toward - 890 nm for large doses (1.4 x 10¹⁷ Si/cm² and 2 x 10 ¹7 Si/cm²). This behaviour is also observed for the unpassivated samples as show in Fig. 4. This result proves that all samples contained Si nanocrystals and the size of the QDs grows with respect to implantation dose. The increase in size starts from doses of 1.4 x 10¹⁷ Si/cm² or greater.

In the case of unpassivated samples, PL intensity decreases when fluence is increased from 6 x 10¹⁶ Si/cm² to 2 x 10¹⁷ Si/cm². This discrepancy can be explained by the fact that small QDs are more luminescent than larger QDs when they have not been passivated. In other words, for larger Si-nc sizes, defects are more pronounced in the interface and need to be passivated.

The compromise between the experimental magnitudes of PL intensity and doses were investigated via theoretical calculations and also experimentally for other energy levels and oxide thicknesses however these must be verified owing to other influences such as interference phenomena.

A comparison between the PL signal shapes of unpassivated (Figure 4) and passivated (Figure 3) samples reveals that the latter show that the asymmetries due to both the interfacial states and delocalized states decrease. It can be concluded that the diminution of the PL skewness is nothing more than the result of the passivation of defects and the enhancement of direct emission (confinement) at the expense of interfacial or delocalized states.

### TEM

As described above, some works have demonstrated that the size of Si-nc increases with respect to the implantation fluence. Since controlling the size distribution becomes increasingly more difficult for large fluences and longer annealing time, the choice of TEM measurements were focused only on samples implanted with a fluence of 2 x 10¹⁷ Si/cm² and 60 min annealing.

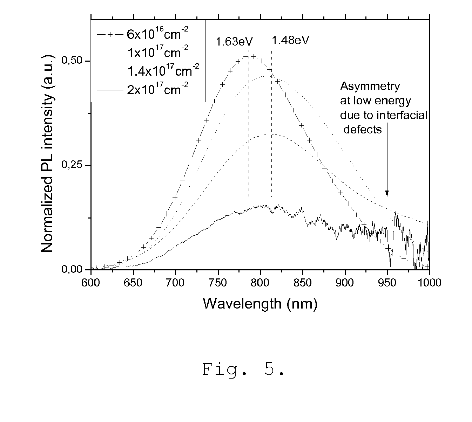

Figure 5 shows TEM images of Si-nc between 2 and 4 nm with cases of few coalescences probably arising from high Si concentration (28 %) and/or drastic annealing conditions. The increase in concentration observing above in depth profiles exctracted from RBS measurements (Figure 2 (b)) could explain this behaviour.

There is clear evidence of quantum confinement of Si QDs into SiO₂ matrix. Controlling the distance between QDs (inter-QD distance) remains a challenge since there is a competition between a controlled precipitation mechanism of Si excess into SiO₂ and the coalescence behaviour. This can influence the charge transport by the tunnelling effect and consequently the total conversion of light into electricity.

### Electrical characterization: I-V characteristics

### Case of single energy implantation(Gaussian profile)

Table 1 shows the photovoltaic properties of the illuminated Si QDs p-n devices made from non-implanted, implanted with two different doses (lines); and non-annealed, annealed, annealed and doped samples. Only PV cells fabricated by implantation annealing and doping (for n-p junction) yield a high electrical responses. However the samples implanted with 2 x 10¹⁷ Si/cm² display better results than those implanted by 1 x 10¹⁷ Si/cm² with an open-circuit voltage of V_{oc} = 46.8 mV and short circuit current of I_{sc} = 10.8 µA for the first and V_{oc} = 142 mV and I_{sc} =2.2 µA for the latter, this discrepancy reveals that at a certain point the implanted concentration and subsequent QDs density and size play an important role in the spectral response. Furthermore Devices rich in silicon QDs can provide more carriers.

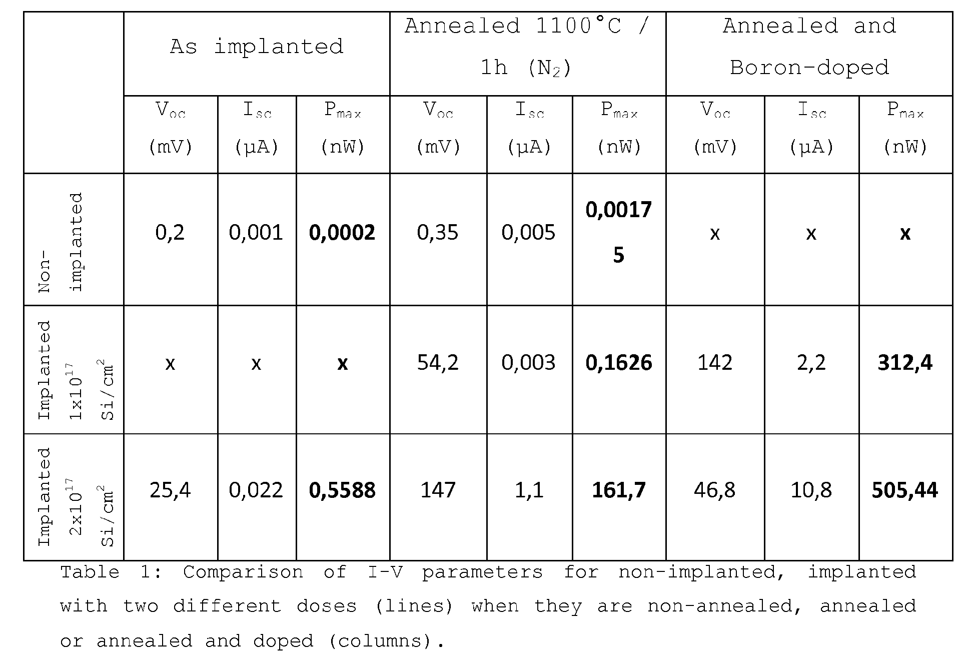

This power generation improvement cannot be explained by the light absorption from bulk Si because cells fabricated from implanted but non-annealed samples do not present this behaviour and their cell parameters are close to zero. One may increase the fluence by more than 2 x 10¹⁷ Si/cm², but the control of QD sizes would become more complex.

The weakest response (V_{oc} = 0,003 mV) of device performed with fluence of 1x10¹⁷ Si/cm² shows clearely the importance of the doping and the necessity of the n-p junction. In general, the non-high values of V_{oc} and Isc could be due to the thickness of the silicon oxide (240 nm).

As there is a direct dependence on light absorption, and an indirect dependence on the electrical conductivity with oxide thickness, an absorption / conductivity compromise must be optimized.

It has been shown that third generation PV devices were successfully achieved for the first time by ion implantation. The difference between the illuminated devices fabricated either from non-annealed samples (no QDs) or annealed samples (presence of QDs) indirectly proves that the generation of one or multiple electron-hole pairs has occurred during the absorption of photons.

RBS measurements showed that Si ions were implanted. TEM and PL reveal that Si QDs (with sizes between 2 and 5 nm) have been formed within SiO₂ matrix after different annealing times.

Finally I-V spectral responses prove that the absorption of light was converted into the electricity by the Si QDs. Surprisingly, the best result was obtained for high fluence implantation for an annealing time of 1 h.

### Case of multiple energy implantations (plateau)

Table 2 shows the photovoltaic properties of the illuminated Si QDs n-p devices made from samples implanted with a Si multiple energy implantations of 20, 35, 80 keV to fluences of 2.1 x 10¹⁶, 4.2 x 10¹⁶ and 1.4 x 10¹⁷ Si+/cm2.

All samples are annealed and Phosphorous-doped. All PV cells fabricated by multiple implantation, annealing and doping ((n-type)Si QD/(p-type)c-Si) yield an electrical responses.

However PV cells fabricated with 5 aluminum contact fingers in the front area display better results than those fabricated with 17 fingers: an open-circuit voltage of V_{oc} = 396 mV and short circuit current of I_{sc} = 18.3 µA for the first and V_{oc} = 105 mV and I_{sc} = 17.3 µA for the latter, this discrepancy is due to the compromise between the shadow and contact resistance losses.

In this example (multiple implantation), the value of Pmax (nW) =7246.8 is 14 higher than in the case of single implantation device where the maximal value is 505 nW(see table 1). It suggests that the whole 150 nm oxide layer is embedded with Si-QDS from the extreme surface to SiO2/S interface. This shows that multiple implantations improves cells efficiency.

**Table 2: Comparison of I-V parameters for two different cells: a cell with 17 aluminum fingers (first line) and a cell with 5 aluminum. All samples used for cells fabrication have been annealed, doped with phosphorous and illuminated under AM1.5G. Here the value of V_{oc} (mV) is 15 higher than in the case of single implantation device (see table 1).**

| | 150 nm SiO₂/(ptype) c-Si samples implanted with a Si multiple energy implantations of 20, 35, 80 keV to fluences of 2.1 x 10¹⁶, 4.2 x 10¹⁶ and 1.4 x 10¹⁷ Si⁺/cm². All samples are annealed and Phosphorous-doped | | |
|---|---|---|---|
| | V_{oc} (mV) | I_{sc} (µA) | Pₘₐₓ (nW) |
| Cells with 17 aluminium contact fingers in the front area | **105** | 17.3 | **1816.5** |
| Cells with 5 aluminium contact fingers in the front area | **396** | 18.3 | **7246.8** |

## Claims

1. Process for the manufacturing of a photovoltaic cell comprising the steps of:
- providing a semiconductor substrate said semiconductor substrate comprising an insulating layer on its top surface;
- implanting semiconductor ions selected from the group consisting of silicon, germanium and their mixture by ionic implantation in the insulating layer for obtaining an implanted insulating layer, the ionic implantation fluence being higher than 1.10¹⁷at./cm², the maximum semiconductor concentration in the insulating layer after implantation being higher than the solubility of the semiconductor in the insulating layer;
- thermally treating the implanted insulating layer for inducing the precipitation of the semiconductor into quantum dots;
- depositing at least two conducting contacts for collecting, in use, the generated current.

2. Process according to claim 1 wherein the thermal treatment is performed at a temperature above 900°C.

3. Process according to claim 1 or 2 wherein the implantation is performed with ions having an average energy between 15 and 100 keV, preferably between 20 and 80 keV.

4. Process according to any of previous claims wherein the semiconductor ions energy distribution is a single energy distribution (Gaussian profile).

5. Process according to claim 4 wherein the semiconductor ion fluence of the ionic implantation is higher than 1,4x10¹⁷at./cm², preferably about 2x10¹⁷at./cm².

6. Process according to any of claims 1 to 3 wherein the semiconductor ions energy distribution is a multiple energy distribution(plateau profile).

7. Process according to claim 6 wherein the semiconductor ion fluence of the ionic implantation is comprised between 2.1x10¹⁶ and 1.4x10¹⁷ at. /cm².

8. Process according to any of previous claims wherein the maximum excess concentration of the implanted ions in the insulating layer is comprised between 20 and 36 atomic percent, preferably about 28 atomic percent.

9. Process according to any of previous claims further comprising the step of implanting dopant, preferably boron or phosphorous, said step being performed after the thermal treatment.

10. Process according to claim 9 wherein the fluence of said dopant is comprised between 7.5x10¹⁴ and 1.5x10¹⁵ at./cm².

11. Process according to any of previous claims wherein the insulating layer thickness is comprised between 100 and 300 nm.

12. Process according to any of previous claims wherein the insulating layer is an oxide of the substrate semiconductor.

13. Process according to any of the claims 1 to 11 wherein the insulating layer is selected from the group consisting of nitride or carbide of the semiconductor substrate.

14. Process according to any of the previous claims wherein the semiconductor substrate is selected from the group consisting of silicon and germanium.
